# DEMANDE DE BREVET EUROPEEN

(11) **EP 4 006 955 A1**
(43) Date de publication de la demande: **01.06.2022**
(21) Numéro de dépôt: 21306639.2
(22) Date de dépôt: 25.11.2021
(51) Int. Cl.: H01L 21/20, H01L 21/02, H01L 21/762, H01L 27/12

(54) **PROCÉDÉ BASSE TEMPÉRATURE DE FABRICATION D'UN SUBSTRAT SEMICONDUCTEUR SUR ISOLANT**

(30) Priorité: 27.11.2020 FR 2012257
(71) Demandeur: Commissariat à l'énergie atomique et aux énergies alternatives, 75015 Paris (FR)
(72) Inventeur: REBOH, Shay, 38054 GRENOBLE Cedex 09 (FR); HARTMANN, Jean-Michel, 38054 GRENOBLE Cedex 09 (FR)
(74) Mandataire: Brevalex

(57) **Abrégé**

L'invention porte sur un procédé de réalisation d'un substrat semi-conducteur sur isolant qui comprenant les étapes suivantes :
- dépôt par épitaxie d'une première couche semi-conductrice (32) sur une couche de lissage (31) supportée par un substrat support (30) monocristallin pour former un substrat donneur ;
- réalisation (F4) d'un assemblage par mise en contact du substrat donneur et d'un substrat receveur (40);
- transfert (F5) sur le substrat receveur de la première couche semi-conductrice (32), de la couche de lissage (31) et d'une partie (34) du substrat support ;
- gravure sélective (F6) de ladite partie (34) du substrat support par rapport à la couche de lissage (31) ;

Le dépôt par épitaxie de la première couche semi-conductrice (32) peut être précédé d'un recuit de préparation de surface du substrat support monocristallin à une température supérieure à 650°C.

Après la gravure sélective de ladite partie (34) du substrat support, le procédé comprend la réalisation des étapes suivantes dans un bâti d'épitaxie :
- gravure sélective (F7) de la couche de lissage (31) par rapport à la première couche semi-conductrice (32);
- dépôt par épitaxie (F8) d'une deuxième couche semi-conductrice (36) sur la première couche semi-conductrice (32).

## Description

### DOMAINE TECHNIQUE

Le domaine de l'invention est celui des circuits intégrés dotés de composants microélectroniques répartis sur plusieurs niveaux, en particulier des transistors superposés. De tels circuits sont généralement qualifiés de dispositifs intégrés en 3 dimensions ou « 3D ». L'invention vise plus spécifiquement un procédé de réalisation d'un tel dispositif à composants superposés au moyen d'un transfert sur un premier niveau de composants d'une couche monocristalline destinée à servir à la fabrication d'un deuxième niveau de composants.

### TECHNIQUE ANTÉRIEURE

D'une manière générale, dans le domaine des circuits intégrés, on cherche continuellement à augmenter la densité de transistors. Pour cela, une solution consiste à répartir les transistors sur plusieurs niveaux de couches semi-conductrices disposées les unes au-dessus des autres pour former un dispositif 3D. Un tel dispositif 3D comporte ainsi généralement un niveau inférieur doté d'une première couche semi-conductrice à partir de laquelle des transistors sont formés et au moins un niveau supérieur doté d'au moins une deuxième couche semi-conductrice à partir de laquelle des transistors sont formés, la première et la deuxième couche semi-conductrice étant superposées.

La réalisation du dispositif 3D peut impliquer la mise en œuvre d'une étape d'assemblage d'un niveau inférieur dans lequel des transistors ont par exemple déjà été réalisés et d'un substrat silicium sur isolant (SOI pour « Silicon On Insulator ») dans lequel on retrouve la couche semi-conductrice d'un niveau supérieur. L'assemblage entre le substrat SOI et le niveau inférieur est généralement effectué par collage.

Le substrat SOI est ensuite aminci jusqu'à la couche semi-conductrice du niveau supérieur. Cet amincissement peut être réalisé par gravure de la face arrière du substrat SOI. De manière alternative, la couche semi-conductrice du niveau supérieur peut être transférée sur le niveau inférieur conformément au procédé Smart Cut^{™} depuis le substrat SOI. Ce transfert comprend, préalablement au collage, l'implantation d'espèces ioniques dans le substrat SOI de sorte à former un plan de fragilisation et, après le collage, la fracture du substrat SOI le long du plan de fragilisation.

Dans les deux cas de figure, la couche d'oxyde enterrée (BOX pour « Buried OXide ») du substrat SOI sert de couche d'arrêt à la gravure d'amincissement, ce qui permet d'obtenir une fine couche semi-conductrice en silicium d'épaisseur uniforme. Ces deux méthodes présentent cependant l'inconvénient d'être relativement coûteuses du fait du coût de fabrication du substrat SOI.

Une solution pour réduire ces coûts consisterait à fabriquer la couche semi-conductrice du niveau supérieur par Smart Cut^{™} non pas à partir d'un substrat SOI mais directement à partir d'un substrat de silicium massif.

Afin d'assurer une rectification de la rugosité de surface post-fracture et d'amincir la couche semi-conductrice à l'épaisseur souhaitée, des procédés tels que des oxydations thermiques présentant un important budget thermique, par exemple de l'ordre de 900-1200°C, sont conventionnellement réalisés. Or un tel budget thermique peut entraîner une dégradation des composants du niveau inférieur de sorte que ces procédés ne sont pas adaptés pour la conception de circuits 3D.

Il est par ailleurs nécessaire d'éliminer des défauts susceptibles d'affecter la mobilité des porteurs de charge qui ont été introduits par l'implantation d'espèces ioniques dans la matrice cristalline de la couche semi-conductrice du niveau supérieur. Une guérison de ces défauts peut conventionnellement être obtenue au moyen d'un traitement thermique à des températures supérieures à 900°C. Un tel traitement thermique est lui aussi susceptible de venir dégrader les composants du niveau inférieur, et cette guérison ne peut donc être mise en œuvre dans le cadre d'une conception de dispositifs 3D.

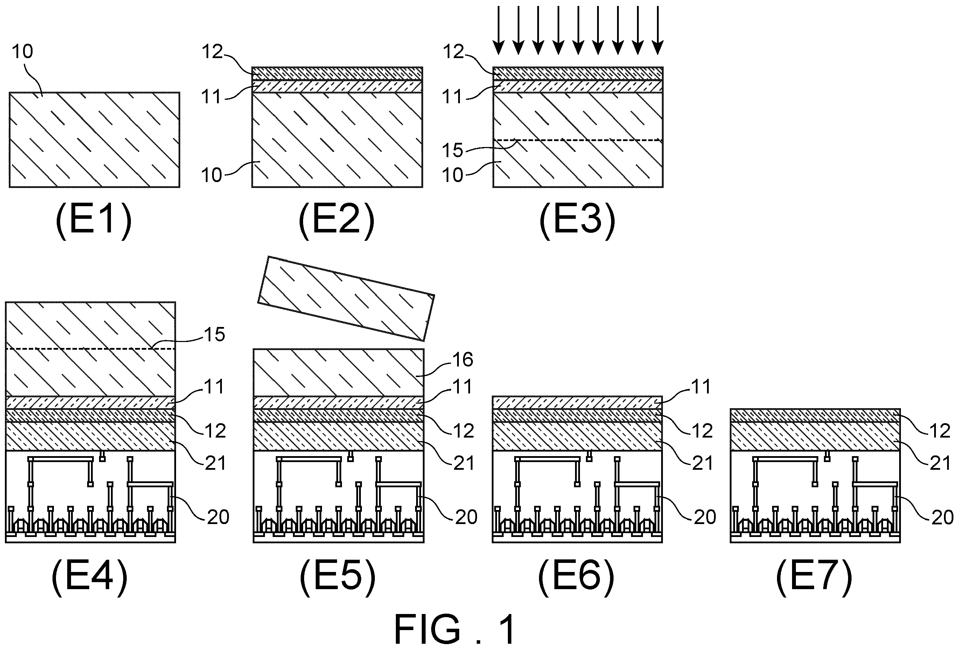

Une solution permettant d'assurer à une température suffisamment basse la rectification de la rugosité de surface post-fracture et d'amincir la couche semi-conductrice à l'épaisseur souhaitée consiste à utiliser une couche d'arrêt à la gravure dans le substrat de silicium massif. Comme représenté sur la figure 1, cette solution comprend lors d'une étape (E1) par la fourniture d'un substrat de silicium massif 10. Lors d'une étape (E2), une couche de SiGe 11 et une couche de Si 12 sont successivement formées par épitaxie sur le substrat de silicium massif 10. Lors d'une étape (E3), il est procédé à l'implantation d'espèces ioniques, par exemple d'hydrogène et/ou d'hélium, dans le substrat de silicium massif 10 de sorte à y former un plan de fragilisation 15. Lors d'une étape (E4), le substrat de silicium massif 10 est collé à un substrat receveur 20, une couche diélectrique 21 étant à l'interface de collage. Puis lors d'une étape (E5), il est procédé au détachement du substrat de silicium massif le long du plan de fragilisation 15 entraînant ainsi le transfert de la couche de Si 12, de la couche de SiGe 11 et d'une portion 16 du substrat de silicium massif sur le substrat receveur 20. La structure obtenue à l'issue du transfert est soumise à un traitement de finition qui comprend lors d'une étape (E6) une première gravure humide de la portion 16 du substrat de silicium massif qui se trouve à la surface de ladite structure, ladite première gravure étant sélective vis-à-vis du matériau de la couche de SiGe 11. Ce traitement de finition comprend ensuite lors d'une étape (E7) une seconde gravure humide de la couche de SiGe 11 qui se trouve à la surface de la structure obtenue à l'issue de la première gravure, ladite seconde gravure étant sélective vis-à-vis du matériau de la couche de Si 12. Ce traitement de finition réalise un lissage et un amincissement. Toutefois, la couche de Si 12 transférée présente toujours des défauts susceptibles d'affecter ses propriétés électriques.

### EXPOSÉ DE L'INVENTION

Un objectif de l'invention est de proposer un procédé de conception de dispositifs 3D dans lequel la couche cristalline du niveau supérieur serait obtenue par transfert à partir d'un substrat de silicium massif et dans lequel la rectification de la rugosité de surface post-fracture, la maîtrise de l'épaisseur de la couche transférée et la guérison des défauts présents dans celle-ci pourraient être obtenue sans dégradation des composants du niveau inférieur.

Elle propose pour ce faire un procédé de réalisation d'un substrat de type semi-conducteur sur isolant, comprenant les étapes suivantes :
- dépôt successif par épitaxie d'une couche de lissage et d'une première couche semi-conductrice sur un substrat support monocristallin pour former un substrat donneur, la couche de lissage formant une couche d'arrêt à la gravure vis-à-vis du matériau du substrat support ;
- réalisation d'un assemblage par mise en contact du substrat donneur et d'un substrat receveur;
- transfert sur le substrat receveur de la première couche semi-conductrice, de la couche de lissage et d'une partie du substrat support ;
- la réalisation d'une gravure sélective de ladite partie du substrat support par rapport à la couche de lissage.

Ce procédé comprend en outre, après la gravure sélective de ladite partie du substrat support, la réalisation des étapes suivantes dans un bâti d'épitaxie :
- gravure sélective de la couche de lissage par rapport à la première couche semi-conductrice ;
- dépôt par épitaxie d'une deuxième couche semi-conductrice sur la première couche semi-conductrice.

Dans le cadre de l'invention, les étapes de gravure sélective de la couche de lissage et de dépôt par épitaxie de la deuxième couche semi-conductrice sont conduites dans le même bâti d'épitaxie, sans remise à l'air et à des températures inférieures ou égales à 500°C.

Certains aspects préférés mais non limitatifs de ce procédé sont les suivants :
- le dépôt par épitaxie de la couche de lissage est précédé d'un recuit de préparation de surface du substrat support monocristallin à une température supérieure à 650°C, de préférence sous H₂ ;
- le recuit de préparation de surface du substrat support monocristallin est réalisé à une température supérieure à 800°C ;
- le recuit de préparation de surface du substrat support monocristallin est précédé d'une étape de retrait d'un oxyde natif présent en surface dudit substrat support ;
- la gravure sélective de la couche de lissage par rapport à la première couche semi-conductrice est une gravure en phase vapeur ;
- le substrat support monocristallin est un substrat de Si monocristallin, la couche de lissage est une couche de SiGe et la première couche semi-conductrice est une couche de Si monocristallin ;
- la couche de lissage présente une concentration en Ge comprise entre 20 et 60% ;
- le substrat support monocristallin est un substrat de Si monocristallin, la couche de lissage est une couche de SiGe et la première couche semi-conductrice est une couche de SiGe de plus faible concentration en Ge que la couche de lissage ;
- la concentration en Ge de la première couche semi-conductrice est au moins 20% plus faible que la concentration en Ge de la couche de lissage ;
- le dépôt par épitaxie de la deuxième couche semi-conductrice est précédé d'un recuit de préparation de surface du substrat receveur de la première couche semi-conductrice à une température inférieure ou égale à 500°C, de préférence sous H₂;
- il comprend, avant la réalisation de l'assemblage, une étape d'oxydation thermique de la première couche semi-conductrice à une température inférieure à 900°C, ladite oxydation thermique venant former une couche diélectrique d'épaisseur comprise entre 5 nm et 50 nm ;
- il comprend avant la réalisation de l'assemblage une étape d'oxydation plasma de la première couche semi-conductrice à une température inférieure à 500°C, ladite oxydation plasma venant former une couche diélectrique ;
- il comprend en outre, avant l'étape de réalisation de l'assemblage, une étape d'implantation d'espèces ioniques dans le substrat support de sorte à y former un plan de fragilisation et l'étape de transfert comprend le détachement du substrat support le long du plan de fragilisation ;
- le substrat receveur intègre un niveau de composants microélectroniques ;
- il est en outre prévu les étapes suivantes ultérieures de :
   - gravure localisée d'une première portion de la seconde couche semi-conductrice de manière à libérer une zone de la couche de lissage ;
   - dépôt par épitaxie d'une troisième couche semi-conductrice sur au moins une moins une partie de la zone libérée de la couche de lissage.
   - les étapes de gravure localisée de la première portion de la seconde couche semi-conductrice et de dépôt par épitaxie de la troisième couche semi-conductrice sont réalisées dans un même bâti d'épitaxie, sans remise à l'air et sont conduites à des températures inférieures ou égales à 500°C ;

- la partie de la zone libérée de la couche de lissage sur laquelle est formée la troisième couche semi-conductrice est une partie à distance d'une portion de seconde couche semi-conductrice qui reste après l'étape de gravure sélective de la première portion de la seconde couche semi-conductrice ;
- il est en outre prévu une étape de gravure localisée préalable de la couche de lissage et de la deuxième couche semi-conductrice afin de former une zone exempte de couche de lissage et de deuxième couche semi-conductrice, l'étape de gravure localisée préalable étant préalable à l'étape de formation de la troisième localisée préalable et étant réalisée de telle manière que la zone exempte de couche de lissage et de deuxième couche semi-conductrice est destinée à séparer la troisième couche semi-conductrice de la deuxième couche semi-conductrice ;
- la troisième couche semi-conductrice est réalisée dans un matériau distinct de celui de la deuxième couche semi-conductrice par au moins l'une des caractéristiques suivantes :
   - une composition chimique,
   - un type de conductivité,
   - une concentration en éléments dopants,
la deuxième couche semi-conductrice comprenant préférentiellement un alliage de silicium-germanium avec un type de conductivité pour lequel les porteurs majoritaires sont des électrons, la troisième couche semi-conductrice comprenant avantageusement du silicium avec un type de conductivité pour lequel les porteurs majoritaires sont des trous.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
- la figure 1 déjà commentée précédemment, illustre un procédé basse température de l'état de l'art ;
- la figure 2 illustre un exemple de réalisation d'un procédé conforme à l'invention ;
- la figure 3 illustre une image AFM de 5 µm par 5 µm d'une surface d'une seconde couche semi-conductrice mesurée après épitaxie de cette dernière dans le cadre d'un procédé de l'art antérieur dans lequel une gravure d'une couche de lissage est réalisée à l'extérieur du bâti d'épitaxie ;
- la figure 4 illustre une image AFM de 5 µm par 5 µm de la surface de la seconde couche semi-conductrice mesurée après épitaxie de cette dernière dans le cadre d'un procédé selon l'invention dans lequel conformément à l'invention la gravure de la couche de lissage est réalisée dans le bâti d'épitaxie ;
- la figure 5 illustre une image AFM de 5 µm par 5 µm de la surface de la seconde couche semi-conductrice mesurée après épitaxie de cette dernière dans le cadre d'un procédé selon l'invention dans lequel il a été introduit du chlorure d'hydrogène dans le cadre de cette étape d'épitaxie ;
- La figure 6 illustre une image AFM de 5 µm par 5 µm de la surface de la seconde couche semi-conductrice mesurée après réalisée après épitaxie de cette dernière dans le cadre d'un procédé selon l'invention dans lequel l'étape d'épitaxie a été optimisée par une stratégie de dépôt/gravure cyclique ;
- la figure 7 illustre une variante de l'exemple de réalisation d'un procédé conforme à l'invention dans lequel il est prévu une première zone de formation de composants PMOS selon l'invention et une zone de formation de composant NMOS formée par épitaxie ultérieure en contact de la couche de lissage.

### DESCRIPTION DÉTAILLÉE

L'invention porte sur un procédé de réalisation d'un substrat, notamment un substrat de type semi-conducteur sur isolant, par transfert d'une couche semi-conductrice sur un substrat receveur.

Dans une application privilégiée de l'invention, le procédé permet de concevoir un dispositif 3D à composants microélectroniques superposés avec un substrat receveur qui intègre des composants déjà fabriqués sur un premier niveau. La couche semi-conductrice transférée peut servir de couche active pour la fabrication de composants sur un niveau superposé au premier niveau. La couche semi-conductrice transférée peut par exemple constituer une région de canal pour un ou plusieurs transistors.

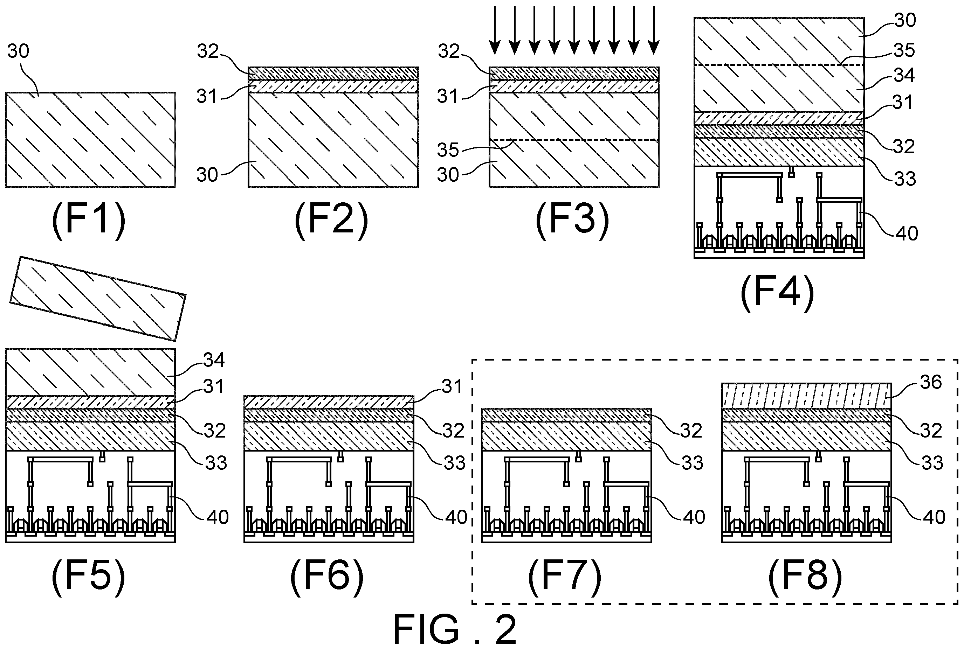

Une mise en œuvre possible du procédé selon l'invention est illustrée par la figure 2. Ce procédé débute lors d'une étape (F1) par la fourniture d'un substrat support monocristallin 30. Une couche de lissage 31 et une première couche semi-conductrice monocristalline 32 sont formées successivement, par épitaxie dans un même bâti d'épitaxie sur le substrat support monocristallin. Il n'y a ainsi aucune exposition à l'air ou à tout autre environnement contaminant entre l'épitaxie de la couche de lissage 31 et l'épitaxie de la première couche semi-conductrice monocristalline 32. Un substrat donneur est ainsi formé qui comprend le substrat support monocristallin 30, la couche de lissage 31 et la première couche semi-conductrice monocristalline 32, cette dernière étant agencée en superficie dudit substrat.

A titre avantageux, le dépôt par épitaxie de la couche de lissage 31 sur le substrat support 30 est précédé, après retrait de l'oxyde natif présent en surface du substrat support 30, d'un recuit de préparation de surface du substrat support monocristallin 30, habituellement sous H₂, à une température supérieure à 650°C, de préférence supérieure à 800°C. Le retrait de l'oxyde natif peut être réalisé en voie chimique humide, par exemple grâce à une immersion dans de l'acide fluorhydrique dilué dans de l'eau, ou au moyen d'un plasma à base de NH₃/NF₃ (avec conversion de l'oxyde natif ou d'un oxyde chimique/thermique en sel d'oxyde et sublimation à des températures inférieures à 200°C). Les inventeurs ont effectivement pu constater qu'une tel recuit de préparation de surface à haute température permet d'obtenir une surface adéquate en termes de nettoyage, de décontamination et d'élimination de contaminants résiduels tels que C, O ou F. Ainsi, là où un recuit à une température inférieure à 650°C va conduire à la croissance épitaxiale d'une couche présentant une important micro-défectivité, un recuit à une température supérieure à 650°C va permettre la croissance épitaxiale basse température (typiquement inférieure à 500°C) d'une couche présentant une micro-défectivité acceptable.

La couche de lissage 31 forme une couche d'arrêt de gravure vis-à-vis du matériau du substrat support 30 et du matériau de la première couche semi-conductrice monocristalline 32. À cet effet, la couche de lissage 31 est en un matériau présentant une composition chimique différente de celle du substrat support 30 et de la première couche semi-conductrice monocristalline 32, le choix des matériaux pouvant être effectué selon la nature de l'agent de gravure et de la sélectivité souhaitée.

Selon un mode de réalisation préféré, le substrat support 30 comprend un premier matériau identique à celui de la première couche semi-conductrice monocristalline 32 et la couche de lissage 31 comprend un second matériau monocristallin différent du premier matériau. Le premier matériau est typiquement du silicium, le second matériau pouvant par exemple être du silicium-germanium.

De préférence, l'épaisseur et la teneur en germanium de la couche de lissage 31 sont choisies de manière à obtenir une couche pseudomorphe, i.e. d'épaisseur inférieure à l'épaisseur critique de relaxation plastique, ce qui limite le risque de générer des défauts cristallins tels que des dislocations. Ainsi, l'épaisseur de la couche de lissage est typiquement comprise entre 5 et 120 nm, de préférence comprise entre 10 et 50 nm. Selon une forme d'exécution particulière de l'invention, la teneur en germanium dans la couche de lissage est comprise entre 20 et 60%, de préférence entre 20 et 40%. L'épaisseur de la première couche semi-conductrice monocristalline 12 est comprise typiquement entre 5 et 100 nm.

Dans une variante de réalisation, le substrat support monocristallin 30 est un substrat de Si monocristallin, la couche de lissage 31 est une couche de SiGe et la première couche semi-conductrice 32 est une couche de SiGe de plus faible concentration en Ge que la couche de lissage 31. Par exemple, la concentration en Ge de la première couche semi-conductrice 32 est au moins 20% plus faible que la concentration en Ge de la couche de lissage 31.

Selon un mode de réalisation, le substrat donneur est recouvert d'une couche de collage, par exemple une couche diélectrique. En variante ou en complément, la couche de collage peut être une couche de Si ou de Ge amorphe et/ou être constituée d'une ou plusieurs couches métalliques, ou toute autre couche permettant un procédé de collage moléculaire. Une couche de collage diélectrique peut être en particulier une couche d'un oxyde ou d'un nitrure d'un matériau semi-conducteur. La couche de collage diélectrique formera tout ou partie de la couche isolante enterrée du substrat semi-conducteur sur isolant. Une formation possible de cette couche diélectrique sur le substrat donneur sera décrite par la suite.

De manière alternative, le substrat donneur n'est pas recouvert d'une telle couche de collage et c'est sa surface libre qui forme la surface du substrat donneur. Dans ce cas, une couche de collage peut être formée sur un substrat receveur auquel sera collé le substrat donneur en vue du transfert de la couche semi-conductrice. En variante, une couche de collage peut être présente à la fois sur le substrat donneur et le substrat receveur.

Le procédé comprend ensuite lors d'une étape (F3) une implantation d'espèces ioniques, par exemple d'hydrogène et/ou d'hélium, dans le substrat support 30 de sorte à y former un plan de fragilisation 35 séparant une portion à transférer par le procédé Smart Cut^{™} (formée de la première couche semi-conductrice monocristalline 32, de la couche de lissage 31 et d'une partie 34 du substrat support) d'une partie massive du substrat support. Cette étape est optionnelle, le transfert pouvant être réalisé par un autre procédé, par exemple par un amincissement mécanique et/ou chimique du substrat donneur par sa face arrière.

Le procédé se poursuit avec une étape (F4) de collage du substrat donneur avec un substrat receveur 40, une couche de collage 33 étant à l'interface de collage. Cette couche de collage 33 peut résulter de la formation préalable d'une couche de collage sur le substrat donneur et/ou sur le substrat receveur. Dans un mode privilégié de réalisation, le substrat receveur intègre des composants tels que des transistors.

Au cours d'une étape (F5), il est ensuite procédé suite au détachement du substrat donneur le long du plan de fragilisation 35, par exemple par apport d'énergie thermique. Cet apport d'énergie thermique est effectué à une température inférieure à 500°C, de préférence inférieure à 400°C.

La structure obtenue après ce détachement comprend ainsi, sur le substrat receveur 40, la couche diélectrique 33, la première couche semi-conductrice monocristalline 32, la couche de lissage 31 et la partie 34 du substrat support qui se retrouve ainsi à la surface de ladite structure. De manière alternative, si le procédé Smart Cut^{™} n'est pas utilisé, cette structure peut être obtenue par un amincissement par la face arrière du substrat donneur.

Après le transfert, la portion du substrat donneur transférée sur le substrat receveur subit un traitement de finition réalisant un lissage (réduction de la rugosité) et un amincissement permettant d'atteindre l'épaisseur désirée pour la couche semi-conductrice transférée.

Ce traitement de finition comprend lors d'une étape (F6) une première gravure de préférence humide de la partie 34 du substrat support, qui se trouve à la surface de la structure obtenue à l'issue du transfert, ladite gravure étant sélective vis-à-vis du matériau de la couche de lissage 31. Par exemple, si le substrat support est en silicium et la couche intermédiaire est en silicium germanium, l'agent de gravure peut être à base de de TEAH ou de TMAH.

Selon l'invention, à l'issue de l'étape (F6) la couche de lissage 31 ne fait pas l'objet d'une gravure chimique comme c'est le cas du procédé de l'état de l'art illustré sur la figure 1. Au contraire, selon l'invention, suite à l'étape (F6) le substrat receveur est inséré dans un bâti d'épitaxie et c'est dans ce bâti que la couche de lissage 31 est retirée. Le procédé selon l'invention comprend ainsi la réalisation des étapes suivantes dans un bâti d'épitaxie, à savoir une étape (F7) de gravure sélective de la couche de lissage 31 par rapport à la première couche semi-conductrice 32 suivie d'une étape (F8) de dépôt par épitaxie d'une deuxième couche semi-conductrice 36 sur la première couche semi-conductrice 32. Ces étapes (F7) et (F8) sont conduites à une température inférieure ou égale à 500°C.

Avantageusement, préalablement à l'étape (F7) de gravure sélective de la couche de lissage 31, le procédé peut comprendre une étape de retrait de l'oxyde natif présent en surface de la couche de lissage 31 en voie chimique humide ou par plasma, comme décrit ci-dessus.

Selon l'invention, la surface de la première couche semi-conductrice 32 utilisée pour faire croitre par épitaxie la seconde couche semi-conductrice 36 est lisse à l'échelle atomique et exempte de tout contaminant résiduel. Elle a en effet été déposée juste après la couche de lissage 31, dans l'environnement ultra-propre d'un bâti d'épitaxie. Par ailleurs, les étapes (F7) et (F8) étant réalisées dans le même bâti d'épitaxie, cette surface n'est pas exposée à des contaminants puisqu'il n'y a pas de remise à l'air. Ainsi cette surface ne nécessite pas, suite à l'étape (F7) et avant l'étape (F8), la mise en œuvre d'un recuit de préparation de surface haute température qui serait susceptible de venir dégrader des composants intégrés dans le substrat receveur.

La gravure sélective de la couche de lissage 31 par rapport à la première couche semi-conductrice 32 est une gravure en phase vapeur, par exemple avec des précurseurs comme le dichlore (Cl₂) ou l'acide chlorhydrique (HCl). Avec une pression partielle élevée d'HCl dans la chambre d'épitaxie (de l'ordre de 180 Torr, dans un mode de réalisation préférentiel), la sélectivité de la gravure de SiGe par rapport au Si est, à 500°C, supérieure à 40 pour un taux de 20% de germanium, supérieure à 110 pour un taux de 35% de germanium et encore plus élevée pour un taux de 40% de germanium. Des pressions partielles d'HCl plus élevées encore, dans la gamme 200 - 600 Torr, peuvent être utilisées pour bénéficier de telles sélectivités tout en gravant à 500°C la couche de lissage 31 à des vitesses de plusieurs nm.min⁻¹.

Le dépôt par épitaxie de la deuxième couche semi-conductrice 36 peut être précédé, dans le bâti d'épitaxie, d'un recuit de préparation de surface de la première couche semi-conductrice 32 à une température inférieure ou égale à 500°C.

La deuxième couche semi-conductrice 36 peut être une couche de Si d'épaisseur typiquement comprise entre 5 et 150 nm. Alternativement, la deuxième couche semi-conductrice 36 peut être une couche de SiGe d'épaisseur typiquement comprise entre 5 et 150 nm et dont le taux de germanium est de préférence compris entre 20% et 60% afin d'obtenir une couche pseudomorphe.

Des hydrures d'ordre élevés, comme le disilane (Si₂H₆), le trisilane (Si₃H₈) ou le tetrasilane (Si₄H₁₀), peuvent être employés afin de réaliser, à des pressions de plusieurs dizaines de Torr et à des températures inférieures ou égales à 500°C, une deuxième couche semi-conductrice 36 en Si. Des précurseurs chlorés comme l'HCl peuvent être injectés en même temps afin de guérir la surface de croissance, en gravant préférentiellement les zones défectueuses ou amorphes. Des stratégies de dépôt/gravure cyclique, avec par exemple du Cl₂ comme gaz de gravure, peuvent être employées à cette même fin. Pour une deuxième couche semi-conductrice 36 en SiGe, des précurseurs hydrogénés comme le silane (SiH₄), le disilane, le germane (GeH₄) ou le digermane (Ge₂H₆), permettent d'atteindre des vitesses de croissance de plusieurs nm.min⁻¹ (à des pressions de plusieurs dizaines de Torr et à des températures inférieures ou égales à 500°C). Des précurseurs chlorés et des stratégies de dépôt/gravure cyclique peuvent être mises en œuvre, comme pour le Si, afin d'obtenir des couches SiGe lisses et monocristallines.

On a vu précédemment que le substrat donneur pouvait être recouvert d'une couche d'oxyde, celle-ci étant notamment destinée à constituer une zone tampon entre l'interface de collage et les composants restant à fabriquer dans le deuxième niveau de manière à ce que ceux-ci disposent de caractéristiques électriques optimales comme par exemple une faible densité d'états de surface à l'interface entre la couche active et la couche d'oxyde.

Une difficulté tient à la présence de la couche de lissage typiquement en silicium-germanium qui fait qu'un budget thermique d'oxydation trop important ne doit pas être apporté afin d'éviter une diffusion du germanium et un relâchement des contraintes (formation de dislocations) de la couche de silicium-germanium.

L'invention propose dans un mode de réalisation possible de venir former une fine couche diélectrique au moyen d'un traitement thermique basse température. Le procédé comprend alors avant la réalisation de l'assemblage une étape d'oxydation thermique de la première couche semi-conductrice 32 à une température inférieure à 900°C, de préférence inférieure à 800°C, ladite oxydation thermique venant former une couche diélectrique d'épaisseur comprise entre 5 nm et 50 nm qui dans une réalisation possible peut être, à l'étape de réalisation de l'assemblage, à l'interface des substrats donneur et receveur mis en contact. Cette couche diélectrique peut faire l'objet d'un épaississement au moyen du dépôt d'un diélectrique à basse température, par exemple du SiN ou du SiO₂ déposé par PECVD. Ce dépôt peut ainsi être réalisé à une température allant jusqu'à 500°C s'il est réalisé avant la formation du plan de fragilisation par implantation H/He. Il peut être réalisé à une température inférieure à 250°C dans le cas contraire.

Dans un autre mode de réalisation, le procédé peut comprendre, avant la réalisation de l'assemblage, une étape d'oxydation plasma de la première couche semi-conductrice à une température inférieure à 500°C, ladite oxydation plasma venant former une couche diélectrique qui dans une réalisation possible peut être, à l'étape de réalisation de l'assemblage, à l'interface des substrats donneur et receveur mis en contact.

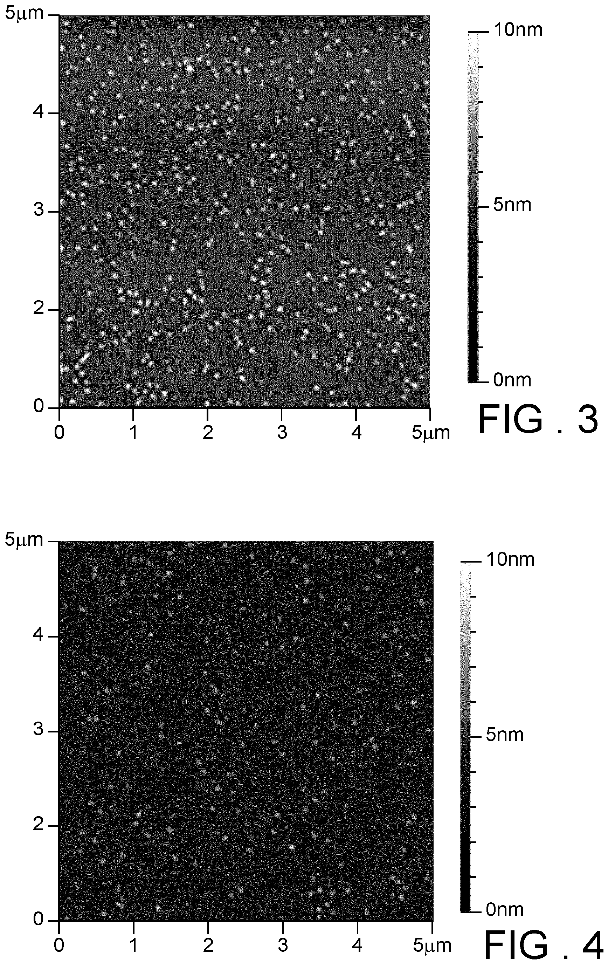

Afin d'illustré les avantages d'un procédé de réalisation selon l'invention, les inventeurs ont réalisé une campagne de mesures comparatives entre les procédés tels que mis en œuvre dans l'art antérieur et les différentes possibilités de l'invention. Les figures 3 à 6 illustres les images AFM 5 µm par 5 µm de la surface de la deuxième couche semi-conductrice 36 après l'étape de dépôt par épitaxie de cette dernière telles qu'elles ont été obtenues lors de cette campagne de mesures.

Ainsi la figure 3 illustre l'état de surface de la deuxième couche semi-conductrice 12 telle qu'elle a été obtenue lorsque, conformément à l'art antérieur illustré sur la figure 1, l'étape de gravure de la couche de lissage a été réalisée en dehors du bâti d'épitaxie et qu'il y a donc eu une remise à l'air. On observe sur cette image AFM un certain nombre de protrusions (en blanc) correspondant à des défauts de surface et/ou des défauts de croissance épitaxiale. Il en résulte que la deuxième couche semi-conductrice 12 présente une topographie locale relativement importante qui peut être liée à la formation de polysilicium.

La figure 4 illustre l'état de surface de la deuxième couche semi-conductrice 36 telle qu'elle a été obtenue lorsque, conformément à l'invention, l'étape de gravure de la couche de lissage 32 a été réalisée dans le bâti d'épitaxie utilisé dans le cadre du dépôt de la deuxième couche semi-conductrice 36 ceci sans remise à l'air entre ladite gravure et l'étape de dépôt de la deuxième couche semi-conductrice 36. On observe sur cette image AFM un nombre, et donc une densité, de protrusions réduits vis-à-vis de l'art antérieur. Ainsi, la deuxième couche semi-conductrice 36 présente une topographie locale améliorée vis-à-vis d'une deuxième couche semi-conductrice selon l'art antérieur.

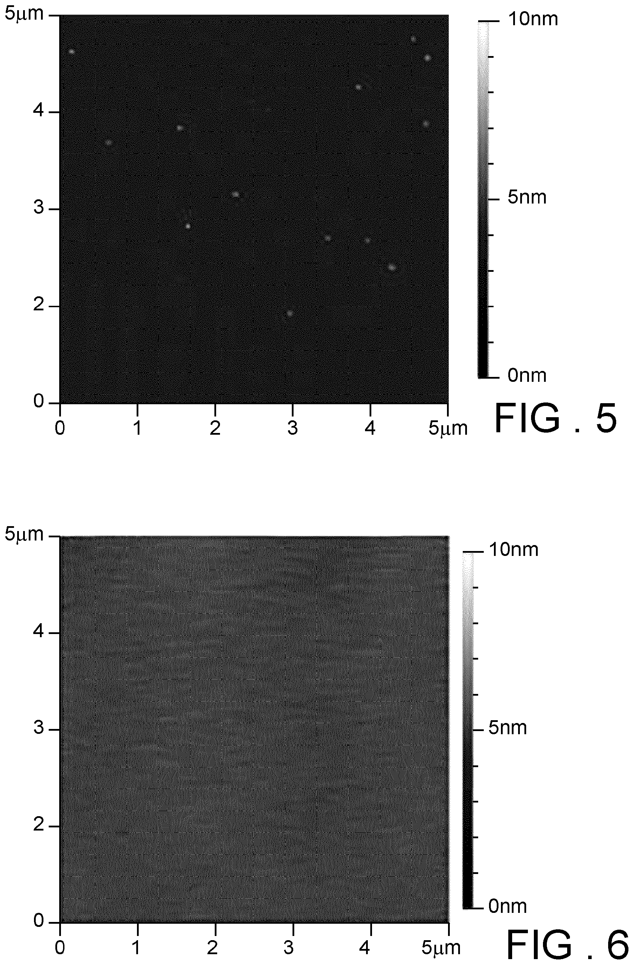

La figure 5 illustre l'état de surface de la deuxième couche semi-conductrice 36 telle qu'elle a été obtenue lorsque, conformément à une possibilité de l'invention, du Chlorure d'hydrogène a été injecté dans le bâti d'épitaxie lors de l'étape de dépôt de la deuxième couche semi-conductrice 36. Une telle injection de chlorure d'hydrogène permet de guérir la surface de croissance. On observe ainsi sur cette image AFM un nombre, et donc une densité, de protrusions fortement réduits vis-à-vis d'un procédé selon l'invention ne mettant pas en œuvre une telle injection. Ainsi, selon cette possibilité, la deuxième couche semi-conductrice 36 présente une topographie locale particulièrement améliorée vis-à-vis d'une deuxième couche semi-conductrice 36 selon l'art antérieur.

La figure 6 illustre l'état de surface de la deuxième couche semi-conductrice 36 telle qu'elle a été obtenue lorsque, conformément à une possibilité particulièrement avantageuse de l'invention, une stratégie de dépôt/gravure cyclique à partir d'un gaz chloré, ici du dichlore, a été mise en place dans le cadre de l'étape de dépôt de la deuxième couche semi-conductrice 36. On observe ainsi sur cette image AFM qu'aucune protrusions n'est présente montrant une guérison de la surface de lissage et une qualité cristallographique particulièrement optimisée de la deuxième couche semi-conductrice 36. Ainsi, selon cette possibilité et comme montré sur la figure 6, la deuxième couche semi-conductrice 36 présente une topographie optimisée vis-à-vis d'une deuxième couche semi-conductrice 36 selon l'art antérieur et des autres possibilités de l'invention.

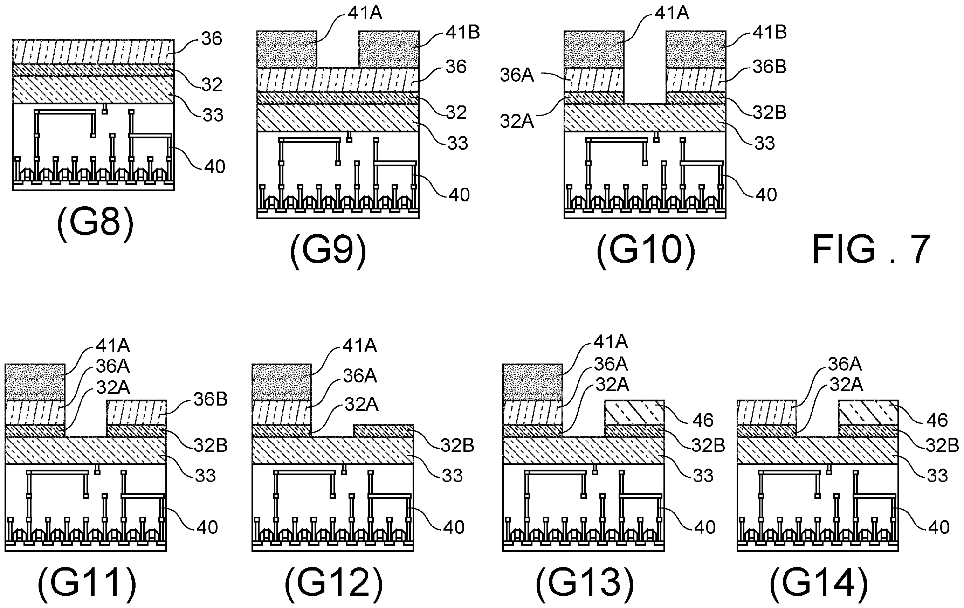

Selon une variante de l'invention, illustrée par le procédé de réalisation montré sur la figure 7, le procédé selon l'invention peut être mis en œuvre afin de permettre former en contact de la couche de lissage 32, 32A, 32B, une deuxième couche de semi-conductrice 36A d'un premier type conformément à l'invention et une troisième couche semi-conductrice 46 d'un deuxième type.

On notera que si selon la présente variante de l'exemple de réalisation, les premier et deuxième types de couche correspondant respectivement à a deuxième et la troisième couche semi-conductrice 36A, 46 se distinguent par la composition de ces couches et leur type de conductivité, selon l'invention et sans sortir de son cadre, les matériaux de la deuxième et de la troisième couche semi-conductrice 36A, 46 peuvent bien entendu se distinguer par au moins l'une des caractéristiques suivantes :
- une composition chimique,
- un type de conductivité,
- une concentration en éléments dopants.

Ainsi, selon la présente variante illustrée sur la figure 7, la deuxième couche semi-conductrice 36 peut être destinée à la formation de composant P-MOS et comprendre, pour se faire un alliage de silicium-germanium SiGe avec un type de conductivité pour lequel les porteurs majoritaires sont des électrons (dopage N). La troisième couche semi-conductrice 46 est destinée à la formation de composant N-MOS et comprend pour se faire du silicium avec un type de conductivité pour lequel les porteurs majoritaires sont des trous (dopage P).

Comme montré sur la figure 7, le procédé selon la présente variante de l'invention comprend, outre les étapes illustrées sur la figure 2 et déjà discutées dans le cadre de l'exemple de réalisation l'invention, les étapes ultérieures suivantes :
- après l'étape dépôt par épitaxie (F8 sur la figure 2, G8 sur la figure 7) de la deuxième couche semi-conductrice 36, formation G9 d'un masque 41A, 41B par lithographie protégeant une première portion 36B de la deuxième couche semi-conductrice 36 correspondant à la partie 32B de la couche de lissage 32 destinée à être recouverte par la troisième couche semi-conductrice 46 et une deuxième portion 36A de la deuxième couche semi-conductrice 36 à distance de la première portion 36B, une troisième portion de la couche semi-conductrice 36, séparant la première et la deuxième portion 36B, 36A, étant libre de masque 41A, 41B,- gravure localisée G10 de la deuxième couche semi-conductrice 36 et de la couche de lissage 32 afin de supprimer la zone de la deuxième couche semi-conductrice 36 et de la couche de lissage 32 non protégée par le masque 41A, 41B, la couche diélectrique 33 formant couche d'arrêt de la gravure localisée, la zone de la couche diélectrique ainsi libérée de deuxième couche semi-conductrice 36 et de couche de lissage 32 séparant les première et deuxième portion 36B, 36A de la deuxième couche semi-conductrice 36,
- suppression G11 de la partie 41B du masque 41A, 41B recouvrant la première portion 36B de la deuxième couche semi-conductrice 36 correspondant à la partie 32B de la couche de lissage 32 destinée à être recouverte par la troisième couche semi-conductrice 46, la partie 41A du masque 41A, 41B recouvrant la deuxième portion 36A de la deuxième couche semi-conductrice 36 étant conservée,
- gravure localisée G12 de la première portion 36B de la deuxième couche semi-conductrice 36 de manière à libérer une zone 32B de la couche de lissage, la deuxième portion 36A de la deuxième couche semi-conductrice 36 et la zone 32A correspondante de la couche de lissage 32 restant protégées par la partie 41A restante du masque 41A, 41B,
- dépôt par épitaxie G13 de la troisième couche semi-conductrice en contact de la de la zone 32B libérée de la couche de lissage 32, la deuxième portion 36A de la deuxième couche semi-conductrice étant protégée par la partie 41A restante du masque 41A, 41B,
- suppression G14 du reste de la partie 41A restante du masque 41A, 41B.

De manière avantageuse et conformément au principe de l'invention, les étapes de gravure localisée G12 de la première portion de la deuxième couche semi-conductrice 36 et de dépôt par épitaxie G13 de la troisième couche semi-conductrice en contact de la de la zone 32B libérée de la couche de lissage 32 peuvent être réalisées dans un même bâti d'épitaxie, sans remise à l'air et être conduites à des températures inférieures ou égales à 500°C.

Selon cette variante, il est possible de former sur un même support deux régions bénéficiant des avantages de l'invention, celles correspondant à la deuxième couche semi-conductrice et à la troisième couche semi-conductrice, présentant des caractéristique distinctes l'une de l'autre et ainsi pouvoir facilement combiné sur ce même support deux types de technologie, tels que des circuits P-MOS, pour la région correspondant à la deuxième couche semi-conductrice 36A, avec des circuits N-MOS, pour la région correspondant à la troisième couche semi-conductrice 46.

## Revendications

1. Procédé de réalisation d'un substrat de type semi-conducteur sur isolant, comprenant les étapes suivantes :
- dépôt successif par épitaxie d'une couche de lissage (31) et d'une première couche semi-conductrice (32) sur un substrat support (30) monocristallin pour former un substrat donneur, la couche de lissage formant une couche d'arrêt à la gravure vis-à-vis du matériau du substrat support ;
- réalisation (F4) d'un assemblage par mise en contact du substrat donneur et d'un substrat receveur (40);
- transfert (F5) sur le substrat receveur de la première couche semi-conductrice (32), de la couche de lissage (31) et d'une partie (34) du substrat support ;
- la réalisation (F6) d'une gravure sélective de ladite partie (34) du substrat support par rapport à la couche de lissage (31) ;
ledit procédé étant **caractérisé en ce qu'**il comprend en outre, après la gravure sélective de ladite partie (34) du substrat support, la réalisation des étapes suivantes dans un même bâti d'épitaxie et sans remise à l'air :
- gravure sélective (F7) de la couche de lissage (31) par rapport à la première couche semi-conductrice (32);
- dépôt par épitaxie (F8) d'une deuxième couche semi-conductrice (36) sur la première couche semi-conductrice (32),
dans lequel les étapes de gravure sélective (F7) de la couche de lissage (31) et de dépôt par épitaxie (F8) de la deuxième couche semi-conductrice (36) sont conduites à des températures inférieures ou égales à 500°C.

2. Procédé selon la revendication 1, dans lequel le dépôt par épitaxie de la couche de lissage (31) est précédé d'un recuit de préparation de surface du substrat support monocristallin (30) à une température supérieure à 650°C, de préférence sous H₂.

3. Procédé selon la revendication 1 ou 2, dans lequel la gravure sélective (F7) de la couche de lissage (31) par rapport à la première couche semi-conductrice (32) est une gravure en phase vapeur.

4. Procédé selon l'une des revendications 1 à 3, dans lequel le substrat support monocristallin (30) est un substrat de Si monocristallin, la couche de lissage (31) est une couche de SiGe et la première couche semi-conductrice (32) est une couche de Si monocristallin.

5. Procédé selon l'une des revendications 1 à 4, dans lequel le substrat support monocristallin (30) est un substrat de Si monocristallin, la couche de lissage (31) est une couche de SiGe et la première couche semi-conductrice (32) est une couche de SiGe de plus faible concentration en Ge que la couche de lissage (31).

6. Procédé selon l'une des revendications 1 à 5, dans lequel le dépôt par épitaxie de la deuxième couche semi-conductrice (36) est précédé d'un recuit de préparation de surface du substrat receveur de la première couche semi-conductrice à une température inférieure ou égale à 500°C, de préférence sous H₂.

7. Procédé selon l'une des revendications 1 à 6, comprenant, avant la réalisation de l'assemblage, une étape d'oxydation thermique de la première couche semi-conductrice à une température inférieure à 900°C, ladite oxydation thermique venant former une couche diélectrique d'épaisseur comprise entre 5 nm et 50 nm.

8. Procédé selon l'une des revendications 1 à 6, comprenant avant la réalisation de l'assemblage une étape d'oxydation plasma de la première couche semi-conductrice à une température inférieure à 500°C, ladite oxydation plasma venant former une couche diélectrique.

9. Procédé selon l'une des revendications 1 à 8, comprenant en outre, avant l'étape (F4) de réalisation de l'assemblage, une étape (F3) d'implantation d'espèces ioniques dans le substrat support (30) de sorte à y former un plan de fragilisation (35) et dans lequel l'étape de transfert (F5) comprend le détachement du substrat support le long du plan de fragilisation.

10. Procédé selon l'une des revendications 1 à 9, dans lequel le substrat receveur intègre un niveau de composants microélectroniques.

11. Procédé selon l'une quelconque des revendications 1 à 10, dans lequel il est en outre prévu les étapes suivantes ultérieures de :
- gravure localisée (G11) d'une première portion (36B) de la seconde couche semi-conductrice (36) de manière à libérer une zone (32B) de la couche de lissage (32) ;
- dépôt par épitaxie (G12) d'une troisième couche semi-conductrice (46) sur au moins une moins une partie de la zone (32B) libérée de la couche de lissage (32).

12. Procédé selon la revendication 11, dans lequel les étapes de gravure localisée (G11) de la première portion (36B) de la seconde couche semi-conductrice (36) et de dépôt par épitaxie (G12) de la troisième couche semi-conductrice (46) sont réalisées dans un même bâti d'épitaxie, sans remise à l'air et sont conduites à des températures inférieures ou égales à 500°C.

13. Procédé selon la revendication 11 ou 12, dans lequel la partie de la zone (32B) libérée de la couche de lissage (32) sur laquelle est formée la troisième couche semi-conductrice (46) est une partie (32B) à distance d'une portion (36A) de seconde couche semi-conductrice (36) qui reste après l'étape de gravure sélective (G11) de la première portion (36B) de la seconde couche semi-conductrice (36).

14. Procédé selon l'une quelconque des revendications 11 à 13, dans lequel il est en outre prévu une étape de gravure localisée préalable de la couche de lissage (32) et de la deuxième couche semi-conductrice (36) afin de former une zone exempte de couche de lissage (32) et de deuxième couche semi-conductrice (36), l'étape de gravure localisée préalable étant préalable à l'étape de formation de la troisième couche semi-conductrice (46) et étant réalisée de telle manière que la zone exempte de couche de lissage (32) et de deuxième couche semi-conductrice (36) est destinée à séparer la troisième couche semi-conductrice de la deuxième couche semi-conductrice.

15. Procédé selon l'une quelconque des revendications 11 à 14, dans lequel la troisième couche semi-conductrice (46) est réalisée dans un matériau distinct de celui de la deuxième couche semi-conductrice (32, 32B) par au moins l'une des caractéristiques suivantes :
- une composition chimique,
- un type de conductivité,
- une concentration en éléments dopants,
la deuxième couche semi-conductrice (36, 36B) comprenant préférentiellement un alliage de silicium-germanium avec un type de conductivité pour lequel les porteurs majoritaires sont des électrons, la troisième couche semi-conductrice (46) comprenant avantageusement du silicium avec un type de conductivité pour lequel les porteurs majoritaires sont des trous.
